(19) Europäisches Patentamt
European Patent Office
Office européen des brevets

(11) **EP 4 542 865 A1**

(12) **DEMANDE DE BREVET EUROPEEN**

(43) Date de publication:
**23.04.2025 Bulletin 2025/17**

(21) Numéro de dépôt: **24205740.4**

(22) Date de dépôt: **10.10.2024**

(51) Classification Internationale des Brevets (IPC):
**H03M 13/45** (2006.01) **G06F 11/08** (2006.01)
**H03M 13/15** (2006.01)

(52) Classification Coopérative des Brevets (CPC):
**H03M 13/453; G06F 11/08; H03M 13/152;
H03M 13/1565**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité: **19.10.2023 FR 2311320**

(71) Demandeur: **Commissariat à l'Energie Atomique
et aux Energies
Alternatives
75015 Paris (FR)**

(72) Inventeur: **GHERMAN, Valentin
38054 GRENOBLE CEDEX 09 (FR)**

(74) Mandataire: **Atout PI Laplace
Immeuble Up On
25 Boulevard Romain Rolland
CS 40072
75685 Paris Cedex 14 (FR)**

(54) **PROCÉDÉ ET DISPOSITIF DE CORRECTION D'ERREURS DANS LES MÉMOIRES RÉSISTIVES**

(57) L'invention concerne un dispositif et un procédé de lecture d'un mot de code dans une mémoire résistive protégée par un ECC où chaque cellule mémoire comprend des dispositifs résistifs pour stocker un bit d'un mot de code. Le procédé (700) permet de sélectionner (740, 750) en fonction de la valeur d'un syndrome, un mot corrigé après un premier décodage (720) sans inversion de weak-bits ou un mot corrigé après un second décodage (730) avec inversion de weak-bits. Si le syndrome calculé détermine que le premier décodage a indiqué une erreur non-corrigeable, ou détermine que le second décodage n'a indiqué ni une erreur non-corrigeable ni une n-erreur (i.e. un maximum de n bits erronés par mot de code), le mot sélectionné est le mot corrigé avec inversion des weak-bits. Dans le cas contraire, le mot sélectionné est le mot corrigé sans inversion des weak-bits.

Fig. 7

EP 4 542 865 A1

## Description

### Domaine technique

L'invention se situe dans le domaine des mémoires résistives ou RRAM pour « Resistive Random Access Memory » selon la terminologie anglo-saxonne, et concerne plus particulièrement un procédé et un dispositif permettant d'améliorer la correction d'erreurs dans des mémoires résistives, notamment des mémoires de type 1T1R et 2T2R.

### Etat de la technique

Les mémoires résistives RRAM sont des mémoires non-volatiles présentant une vitesse de fonctionnement élevée, une faible consommation d'énergie électrique et une grande durée de vie. Pour ces raisons, les mémoires résistives sont des candidates prometteuses pour remplacer à la fois les mémoires vives et les mémoires non-volatiles actuelles telles que les mémoires de type flash.

Il existe plusieurs technologies de mémoires résistives. On peut notamment citer les mémoires résistives à pont conducteur, également appelées CBRAM (pour « Conductive-Bridging Random-Access Memory » selon la terminologie anglo-saxonne), ou les mémoires résistives à base d'oxyde, également appelées OxRAM (pour « Oxide-based Random-Access Memory » selon la terminologie anglo-saxonne), ou encore les mémoires à changement de phase, également appelées PCM (pour « Phase Change Memory » selon la terminologie anglo-saxonne).

Une mémoire résistive est composée d'une multitude de cellules mémoires résistives agencées en lignes et colonnes de manière à former une matrice. Une cellule mémoire RRAM est dotée d'au moins un élément résistif dont on peut modifier la conductance.

Typiquement, une cellule mémoire RRAM dans son état initial a une structure métallique isolante et est dans un état de haute résistance (HRS) (pour « High Resistance State » selon la terminologie anglo-saxonne). Avant leur utilisation, certains types de mémoire résistive, telles que les mémoires OxRAM ou CBRAM, nécessitent une activation électrique. L'application d'une impulsion haute tension externe à travers la cellule RRAM permet la formation de chemins conducteurs dans la couche de commutation et la cellule RRAM est commutée dans un état à faible résistance (LRS) (pour « Low Resistance State » selon la terminologie anglo-saxonne). Le processus général de cette rupture de la structure isolante de la cellule est généralement appelé «électroformage» (ou « forming » selon la terminologie anglo-saxonne).

Le matériau diélectrique qui est disposé entre les deux électrodes conductrices de la cellule va permettre à la cellule de basculer de manière réversible entre deux états de résistance HRS et LRS, chacun des états permettant de stocker un bit d'information dans la cellule mémoire.

Pour programmer une cellule mémoire, une tension de programmation est appliquée entre les électrodes de la cellule mémoire. Il peut s'agir d'une tension de programmation dans l'état LRS, ou d'une tension de programmation dans l'état HRS. Cependant, après une opération de programmation, il peut arriver que la cellule mémoire ne passe pas dans l'état de résistance souhaité. Pour cette raison, il est généralement effectué une opération de vérification que la cellule mémoire est correctement programmée en comparant sa valeur de résistance R à une valeur seuil de résistance prédéfinie $R_{REF}$.

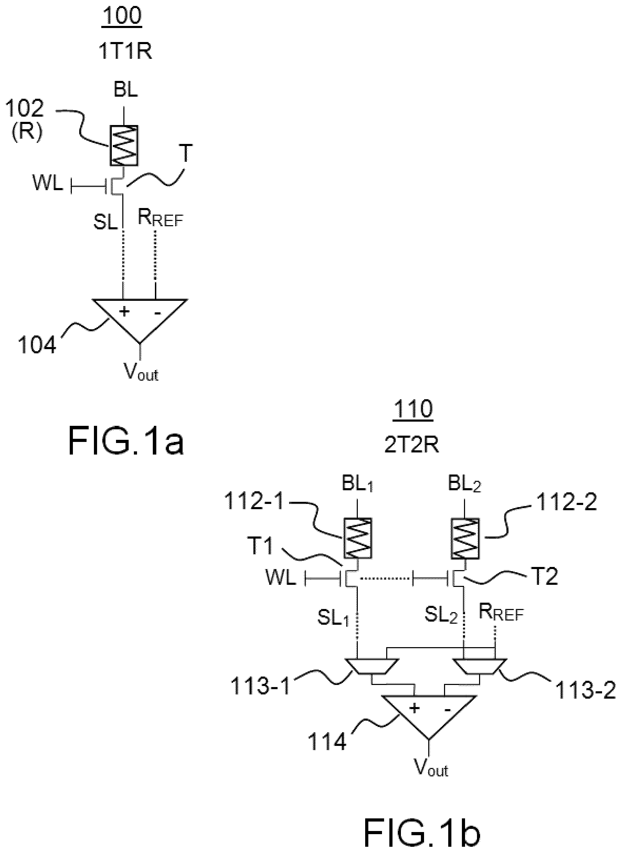

La figure 1a illustre de manière simplifiée une cellule mémoire résistive élémentaire, constituée généralement d'un transistor (T) et d'un composant résistif (R) ou résister (102), où un bit d'information est encodé par la valeur de la résistance électrique du résistor. Pour ces cellules élémentaires, un '0' logique peut par exemple être encodé en programmant le résistor dans un état LRS, et un '1' logique peut alors être encodé en programmant le résistor dans un état HRS, et l'on parle alors d'encodage en mode 1T1R.

Cependant, l'écart entre la plus faible valeur correspondant à un niveau HRS et la plus haute valeur correspondant au niveau LRS, également appelé « fenêtre mémoire », est souvent faible. Dès lors, on utilise couramment un « encodage différentiel » ou encodage 2T2R pour coder une valeur binaire. Un bit d'information peut alors être encodé dans une cellule mémoire dite 2T2R telle qu'illustrée de manière simplifiée sur la figure 1b, et composée de deux cellules élémentaires 1T1R, et comprenant 2 transistors (2T) ou (T1, T2) et 2 résistors (2R) ou (112-1, 112-2).

Comme chacun des états HRS et LRS peut être associé à une valeur logique, i.e. 1 ou 0, on peut considérer que dans une cellule 2T2R un des deux éléments résistifs encode le bit à programmer en version non-inversée tandis que l'autre élément résistif encode le même bit en version inversée. Par exemple, un '1' logique est encodé en programmant le résistor de la première cellule 1T1R dans un état HRS et le résister de la deuxième cellule 1T1R dans un état LRS, et un '0' logique est encodé en programmant le résistor de la première cellule 1T1R dans un état LRS et le résister de la deuxième cellule dans un état HRS.

Lors d'une opération d'écriture dans une cellule mémoire 1T1R ou une cellule mémoire 2T2R, il faut s'assurer que chaque résistance électrique qui doit être programmée à l'état HRS ou l'état LRS est respectivement soit plus grande, soit plus petite qu'une valeur de référence $R_{REF}$. La comparaison d'une résistance électrique avec la valeur $R_{REF}$ est faite par une opération de lecture au cours de laquelle chaque résistance programmée est comparée à la valeur $R_{REF}$ à l'aide d'un amplificateur de détection ou SA (pour « Sense Amplifier» selon la terminologie anglo-saxonne) illustré par le composant 104 sur la figure 1a et 114 sur la figure 1b. Par la suite, cette opération de lecture avec comparaison à une valeur de référence est appelée lecture en mode 1T1R ou lecture 1T1R.

Sur la figure 1a, l'amplificateur de détection 104 réagit à la différence de son entrée 'SL' (provenant de la cellule 1T1R) et de son entrée 'R$_{REF}$' (représentative d'une valeur de résistance électrique de référence R$_{REF}$), pour générer un signal de sortie 'V$_{OUT}$' qui indique l'état résistif de l'élément mémoire de la cellule et renseigne sur la valeur qui est stockée dans la cellule 1T1R.

Sur la figure 1b, l'amplificateur de détection 114 va réagir à une différence sur ses entrées, pour générer un signal de sortie 'V$_{OUT}$'. Dans cette implémentation, un multiplexeur (113-1, 113-2) est respectivement couplé à la sortie (SL1, SL2) de chaque cellule 1T1R pour effectuer une lecture 1T1R par comparaison avec la valeur de référence R$_{REF}$. Lors d'une lecture 2T2R, la sortie de chaque multiplexeur correspond à la valeur de chaque cellule respective (SL1, SL2), et devient une entrée de l'amplificateur de détection 114. La sortie de l'amplificateur de détection 114 réagit alors à la différence en résistance des deux éléments résistifs de la cellule 2T2R (112-1, 112-2) et renseigne sur la valeur qui est stockée dans la cellule 2T2R sélectionnée.

L'usage d'une mémoire implique de fréquentes transitions entre un état HRS et un état LRS et réciproquement, et chaque événement de commutation entre ces états résistifs peut introduire des dommages. De plus, les valeurs des résistances programmées peuvent changer à cause de phénomènes de relaxation, et entraîner une perte de l'information stockée dans la RRAM.

Par ailleurs, les mémoires résistives présentent également une non-uniformité cellule à cellule qui dégrade également la fiabilité de la mémoire. L'origine de cette variabilité est attribuée aux non-uniformités du processus de fabrication telles que l'épaisseur du film de commutation, les dommages de gravure et la rugosité de surface des électrodes.

Ces variations couplées avec des phénomènes de relaxation entraînent que les résistances des mémoires résistives qui sont programmées dans l'état LRS peuvent dériver vers un état HRS, et les résistances qui sont programmées dans l'état HRS peuvent dériver vers un état LRS. Dès lors, ce glissement des valeurs des résistances programmées peut engendrer des erreurs lors des opérations de lecture.

Pour réduire le taux d'erreur des mémoires, une solution courante consiste à utiliser un code correcteur d'erreurs ou ECC (pour « Error Correcting Code » selon la terminologie anglo-saxonne) qui encode les données avant leur écriture en mémoire. Lors de l'encodage de données avec un code ECC, des bits de vérification sont ajoutés aux bits de données, les bits de vérification représentant une information redondante calculée à partir des bits de données, qui permet la détection et la correction des erreurs affectant aussi bien les bits de données que les bits de vérification. L'ensemble des bits de données et des bits de vérification forme un mot de code.

Un type particulier de code correcteur d'erreur est l'ECC binaire et linéaire. Par « code correcteur d'erreur binaire linéaire», il est entendu un ensemble de mots qui sont générés en rajoutant à une pluralité k de bits de données, un nombre défini r de bits de vérification qui est calculé à partir de la pluralité k des bits de données. Les bits de vérification sont générés à partir des bits de données en respectant l'équation (1) suivante :

$$H \cdot v = 0 \qquad (1),$$

où v est un vecteur colonne correspondant à un mot de code (k bits de données et r bits de vérification), et où H correspond à une matrice de parité qui comprend uniquement des valeurs binaires ('0' ou '1') et où, chaque colonne de la matrice est différente des autres colonnes, et comprend au moins une valeur différente de 0.

Lors de la programmation de données dans une mémoire protégée par un ECC, chaque mot mémoire v est programmé pour stocker un mot de code. Lors de la lecture des données présentes dans la mémoire, chaque mot mémoire v est vérifié en évaluant la valeur du produit matriciel $H \cdot v$.

Le résultat de cette opération est un vecteur binaire s appelé « syndrome ». Si le syndrome est un vecteur nul, i.e. chacun de ces bits est égal à zéro, le mot de code est considéré comme correct. Un syndrome non-nul indique la présence d'au moins une erreur. Cette évaluation est formalisée par la formule suivante :

$$H \cdot v = s$$

Quand le syndrome permet d'identifier les positions des bits erronés, le mot de code peut être corrigé.

En présence d'un taux d'erreurs élevé, une solution est d'utiliser des ECCs de plus en plus puissants, i.e. permettant de corriger de plus en plus de bits erronés dans un mot de code. Cependant, cela entraîne un surcoût de plus en plus important en termes de surface de stockage pour les bits de vérification et en termes de latence et de consommation du décodeur ECC.

Une approche pour éviter l'utilisation d'un ECC puissant, est de réduire le taux d'erreurs primaires, c'est-à-dire le taux d'erreurs en sortie du circuit mémoire tel qu'il serait obtenu sans l'utilisation d'un ECC. Pour réduire le taux d'erreurs primaires, une méthode consiste à utiliser des mémoires 2T2R au lieu de mémoires 1T1R. Cependant, il y a des situations où même avec l'utilisation d'une mémoire 2T2R le taux d'erreurs primaires reste élevé.

Aussi, dans les situations où (a) même avec une mémoire 2T2R le taux d'erreurs primaires reste élevé, où (b) le coût d'une mémoire 2T2R est considéré trop important, où (c) il faut choisir un ECC avec un moindre surcoût (et donc une capacité de correction plus faible), une solution est d'identifier des bits, dits bits faibles ou « weak-bits » selon la terminologie anglo-saxonne consacrée, qui sont des bits susceptibles d'être erronés parmi les bits obtenus pendant une opération de lecture mémoire. Cette information est ensuite utilisée pour améliorer la correction d'erreurs.

L'article de V. Gherman, L. Ciampolini, S. Evain et S. Ricavy, "Error Correction Improvement based on Weak-Bit-Flipping for Resistive Memories," Microelectronics Reliability, volume 136, du 2022 décrit une méthode et des dispositifs permettant d'identifier des weak-bits et d'augmenter la capacité de correction d'un ECC en s'appuyant sur l'identification des weak-bits. Le principe consiste à lancer une procédure d'identification de weak-bits seulement si le décodeur ECC indique une erreur non-corrigeable pendant une opération de lecture mémoire. Dans le cas de mémoires 1T1R, cette procédure consiste à comparer la résistance de chaque résister dans le mot lu, d'une part à une valeur de référence légèrement supérieure, et d'autre part à une autre valeur de référence légèrement inférieure, à la valeur de référence normalement utilisée pendant l'opération de lecture. Dans le cas de mémoires 2T2R, cette procédure consiste à comparer entre elles, les résistances de chaque paire de résistors utilisée pour encoder la valeur de chaque bit lu, en appliquant un léger biais résistif d'abord à un des résistors et ensuite à l'autre résistor. Tout bit dont la valeur change lors de ces évaluations est étiqueté comme faible (« weak ») et désigné comme étant un « weak-bit ». Le décodage ECC du mot initial est alors refait avec tous les weak-bits inversés, ce qui permet d'augmenter de façon significative les chances de corrections d'erreurs conventionnellement non-corrigeables et, au final de diminuer le taux d'erreurs de la mémoire.

L'expression « erreurs conventionnellement non-corrigeables » est à comprendre comme signifiant des erreurs qui ne sont pas corrigeables par le décodeur ECC utilisé pour les opérations de lecture, i.e., utilisé de manière conventionnelle avec la capacité de l'ECC.

De manière similaire, l'expression « erreurs conventionnellement corrigeables » est à interpréter comme signifiant des erreurs pouvant être corrigées par le décodeur ECC selon la capacité de l'ECC.

Cette approche consiste à effectuer deux décodages de type 'décodage par décisions dures' par opposition à des approches qui effectuent un premier décodage par décisions dures et un ou plusieurs autres décodages par décisions souples composés.

La demande de brevet US 2016/179616 A1 de Ha Jeong-Seok et al décrit une méthode de lecture et correction d'un mot de code mémorisé dans une mémoire flash qui commence par un décodage par décision dure d'un mot de code lu de la mémoire flash. Si le décodage par décision dure échoue, il est effectué un décodage par décision souple composés de $2^p$ décodages par décisions dures. Ces approches de décodages à décisions mixtes dures et souples ont entre autres inconvénients d'être plus coûteux car nécessitant des capacités de stockage supplémentaires pour stocker les résultats de tous les décodages à décisions dures.

L'approche par double décodage par décisions dures s'avère efficace pour des ECCs qui permettent (a) la correction d'un maximum de n bits erronés par mot de code, maximum qui est désigné dans la suite de la description comme « n-erreur » et (b) la détection de toutes les erreurs qui affectent n+1 bits, nombre qui est désigné dans la suite de la description comme « (n+1)-erreur ».

Cependant, pour un nombre donné de bits de données par mot de code, la détection de (n+1)-erreurs nécessite des ECCs qui ont un bit de vérification (un « check-bit ») de plus par mot de code, par rapport à des ECCs qui permettent juste la correction de n-erreurs. De plus, ce surcoût peut être amplifié dans le cas où il faut avoir des mots de code avec un nombre total de bits qui est un multiple d'une certaine constante D, par exemple un multiple de D=4. Dans ce cas, il est possible que le fait de rajouter un bit de vérification supplémentaire par mot implique aussi le rajout de D cellules par mot au lieu du rajout d'une seule cellule. Ce qui entraîne alors un surcoût multiplié par D.

Aussi, face à la problématique de la correction d'erreurs dans les mémoires résistives, il réside le besoin d'une solution qui pallie les différents inconvénients des solutions connues.

La présente invention répond à ce besoin.

## Résumé de l'invention

L'invention a pour objet une solution permettant d'améliorer la correction d'erreurs dans les mémoires résistives protégées par un code correcteur d'erreurs (ECC).

De manière générale, le principe de l'invention repose sur un procédé qui permet de sélectionner en fonction de la valeur d'un syndrome, un mot corrigé après un premier décodage sans inversion de weak-bits, ou un mot corrigé après un second décodage avec inversion de weak-bits. Si le syndrome calculé détermine que le premier décodage a indiqué une erreur non-corrigeable, ou détermine que le second décodage n'a indiqué ni une erreur non-corrigeable ni une n-erreur (i.e. un maximum de n bits erronés par mot de code), le mot sélectionné est le mot corrigé avec inversion des weak-bits. Dans le cas contraire, le mot sélectionné est le mot corrigé sans inversion des weak-bits.

Avantageusement, le procédé permet d'augmenter le gain en capacité de correction d'erreurs, et/ou permet d'éliminer le surcoût en termes de bits de vérification, en lançant des opérations d'identification et d'utilisation des weak-bits, non seulement suite à la détection d'une erreur non-corrigeable mais aussi en présence de certaines erreurs corrigeables.

Ainsi par exemple, l'identification par un décodeur ECC d'une n-erreur où n est le nombre maximal de bits erronés qui peuvent être corrigés dans un mot de code, est une information utilisée par le procédé de l'invention pour lancer des opérations d'identification et d'utilisation des weak-bits, quelles que soient les propriétés de l'ECC.

Si l'ECC permet la correction de toutes les n-erreurs mais ne permet pas la détection de toutes les (n+1)-erreurs (ce qui s'exprime aussi par le fait que la distance de Hamming minimale entre les mots de code est égale à 2n+1), alors une (n+1)-erreur peut produire un syndrome qui sera identique à celui généré par une n-erreur. Les décodeurs conventionnels d'un tel ECC ne peuvent pas corriger une (n+1)-erreur qui génère le même syndrome qu'une n-erreur. De manière avantageuse, en appliquant le procédé de la présente invention, de telles (n+1)-erreurs peuvent être corrigées même avec un décodeur conventionnel, en identifiant et en inversant des éventuels weak-bits. Cependant, les inventeurs ont constaté que cette approche ouvre un risque de compromettre la correction des n-erreurs. Aussi, afin de minimiser ce risque, dans le cas d'un mot dont le décodage ECC génère un syndrome qui peut correspondre à une n-erreur, les inventeurs ont amélioré le procédé de l'invention dans une variante où il est proposé de décoder un mot mémoire avec et sans inversion de weak-bits, puis de choisir le mot corrigé avec inversion de weak-bits seulement si le syndrome qui en résulte correspond à une erreur qui affecte moins de n bits erronés.

Dans les cas où l'ECC permet la correction de toutes les n-erreurs et aussi la détection de toutes les (n+1)-erreurs (ce qui s'exprime aussi par le fait que la distance de Hamming minimale entre les mots de code est égale à 2n+2), un décodeur conventionnel combiné à des weak-bits peut arriver à la correction de la quasi-totalité des (n+1)-erreurs.

De manière avantageuse, les inventeurs ont développé une approche qui permet la correction des (n+2)-erreurs. Face au problème que les syndromes des (n+2)-erreurs peuvent être identiques à ceux générés par des n-erreurs, et qu'une correction conventionnelle des (n+2)-erreurs n'est alors pas possible, le procédé de la présente invention permet qu'une telle (n+2)-erreur puisse être corrigée même avec un décodeur conventionnel, par l'identification puis l'inversion des éventuels weak-bits. Le risque de compromettre la correction des n-erreurs est adressé comme précédemment en choisissant le mot corrigé avec inversion de weak-bits seulement si le syndrome qui en résulte correspond à une erreur qui affecte moins de n bits erronés.

Pour parvenir au but recherché, il est proposé un dispositif de lecture d'un mot de code stocké dans une mémoire résistive où chaque cellule mémoire comprend des dispositifs résistifs pour stocker un bit d'un mot de code selon la revendication indépendante de dispositif.

Des modes de réalisation alternatifs ou combinés sont proposés dans les revendications dépendantes.

Un autre objet de l'invention couvre tout système électronique de type FPGA ou ASIC comprenant un dispositif selon l'invention.

L'invention couvre aussi un procédé de lecture d'un mot de code stocké dans une mémoire résistive où chaque cellule mémoire comprend des dispositifs résistifs pour stocker un bit d'un mot de code selon la revendication indépendante de procédé.

Des variantes de réalisation sont proposées dans les revendications dépendantes.

Avantageusement, le procédé de la présente invention peut être mis en oeuvre sur des décodeurs conventionnels, simples et rapides, et n'a pas d'impact sur les opérations d'écriture dans les mémoires résistives concernées.

**Description des figures**

La figure 1a et la figure 1b déjà décrites illustrent respectivement des exemples d'implémentation d'une cellule mémoire 1T1R et d'une cellule mémoire 2T2R.

D'autres caractéristiques, détails et avantages de l'invention ressortiront à la lecture de la description faite en référence aux dessins annexés donnés à titre d'exemple et qui représentent, respectivement :

La figure 2 représente un exemple d'un système permettant des opérations d'écriture et de lecture de mots de données dans une mémoire résistive ;

La figure 3 illustre les étapes du procédé de correction d'erreurs de l'invention dans un mode de réalisation ;

La figure 4 illustre une architecture d'un décodeur ECC qui peut être utilisé dans un contrôleur mémoire pour la mise en oeuvre du procédé de l'invention ;

La figure 5 illustre une variante d'architecture d'un décodeur ECC qui peut être utilisé dans un contrôleur mémoire pour la mise en oeuvre du procédé de l'invention ;

La figure 6 illustre un mode de réalisation d'un circuit permettant de sélectionner un mot corrigé ;

La figure 7 illustre les étapes du procédé de correction d'erreurs de l'invention dans un autre mode de réalisation ;

La figure 8 illustre un mode de réalisation d'un circuit permettant de sélectionner un mot corrigé adapté au procédé de la figure 7 ;

La figure 9 montre un graphe comparant les taux de correction d'erreurs selon l'art antérieur et le procédé de la présente invention.

**Description détaillée de l'invention**

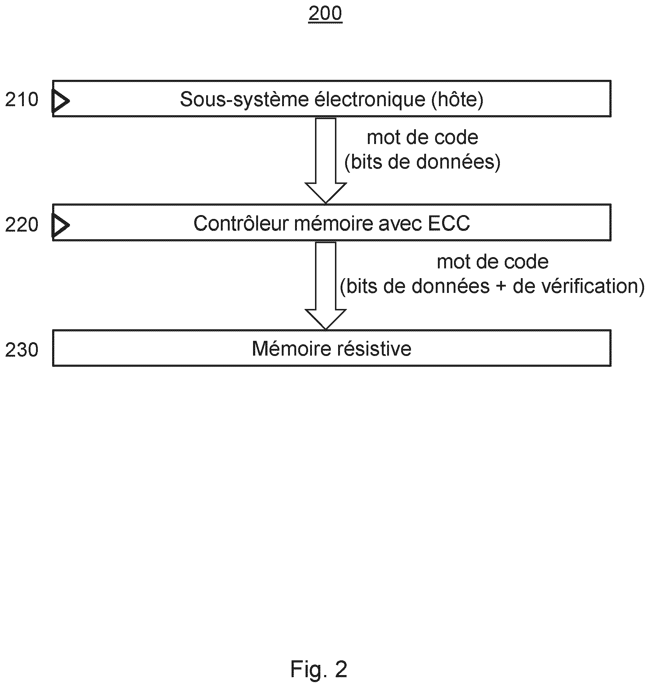

La figure 2 schématise un exemple d'un système permettant des opérations d'écriture et de lecture de mots de données dans une mémoire résistive. L'architecture générale du système 200 intègre un système électronique hôte 210, un contrôleur mémoire 220 et une mémoire résistive RRAM 230.

L'hôte 210 peut être constitué d'un ou plusieurs coeurs de processeur, d'un microcontrôleur, d'un circuit logique programmable (FPGA) (acronyme de l'anglais « Field Programmable Gate Array ») ou d'un circuit intégré spécialisé (ASIC) (acronyme de l'anglais « Application-Specific Integrated Circuit »).

Le contrôleur mémoire 220 pilote les opérations d'écriture et de lecture dans la mémoire résistive 230. Il comprend généralement un encodeur et un décodeur de code correcteur d'erreurs (ECC).

La figure 2 montre aussi le flot de données pendant une opération d'écriture dans la mémoire 230. Avant d'être stockés dans la mémoire 230, les bits d'un mot de données envoyés par le système hôte 210, sont utilisés par l'encodeur ECC du contrôleur mémoire 220 pour générer des bits de vérification, et délivrer un mot de code comprenant les bits de données et les bits de vérification. Ces bits de vérification sont stockés à la même adresse dans la mémoire résistive 230 que les bits de données. Ils peuvent être utilisés par le décodeur ECC du contrôleur mémoire pour corriger les éventuelles erreurs de stockage.

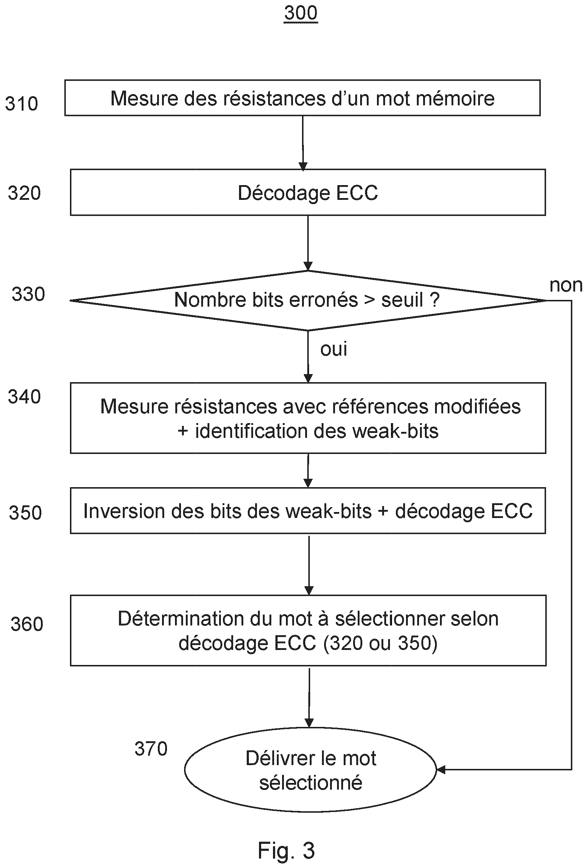

La figure 3 illustre les étapes du procédé de lecture avec correction d'erreurs de l'invention dans un mode de réalisation. Le procédé 300 s'applique lors d'une lecture dans une mémoire protégée par un ECC, et il permet d'améliorer la correction d'erreurs par des opérations d'identification de weak-bits, d'inversion éventuelle de weak-bits, et de sélection d'un mot de code corrigé avec ou sans inversion de weak-bits.

Le procédé de lecture 300 débute par une étape 310 de mesure de résistances des dispositifs résistifs présents dans chaque cellule mémoire d'une adresse lue. Dans les mémoires 1T1R, cette mesure peut consister en une comparaison de la résistance mesurée à une résistance de référence. Dans les mémoires 2T2R, cette mesure peut consister en une comparaison entre les résistances des deux dispositifs résistifs présents dans chaque cellule mémoire.

Suite à cette mesure, une valeur logique est associée à chaque cellule mémoire. Le mot qui en résulte est alors décodé 320 selon le type d'ECC qui a été utilisé pour encoder les données avant leur programmation à l'adresse lue.

L'étape suivante 330 consiste à déterminer si le décodage détecte un nombre de bits erronés supérieur ou non à un seuil prédéfini. Dans un mode de réalisation le seuil est de 'n-1' bits pour un ECC pouvant corriger un maximum de 'n' bits.

Si le nombre de bits erronés ne dépasse pas le seuil, le mot obtenu suite au premier décodage ECC est délivré dans une étape suivante 370 pour être transmis à l'hôte 110.

Si à l'étape 330, il est déterminé que le nombre de bits erronés est supérieur au seuil, avantageusement, le procédé de l'invention utilise des informations complémentaires qui peuvent être obtenues pendant l'étape de décodage pour améliorer la capacité de correction d'erreurs.

En effet, pendant la phase de décodage ECC, il est possible de déterminer la présence d'erreurs détectables mais conventionnellement non-corrigeables. Cette détection revient par exemple à identifier un sous-ensemble de (n+1)-erreurs pour un ECC avec une distance de Hamming minimale égale à 2n+1 ; ou encore à identifier toutes les (n+1)-erreurs et un sous-ensemble de (n+2)-erreurs pour un ECC avec une distance de Hamming minimale égale à 2n+2.

Par ailleurs, l'étape de décodage permet aussi d'identifier la présence d'erreurs conventionnellement corrigeables qui affectent un nombre maximum de bits erronés. Cette détection revient par exemple à identifier n-erreurs pour un ECC ayant une distance de Hamming minimale égale à 2n+1 ou 2n+2.

Une telle détection peut être implémentée par des techniques conventionnelles. Une réalisation possible consiste par exemple, en connaissant les syndromes (i.e. chaque vecteur résultant du produit matriciel $H \cdot v$) générés par toutes les n-erreurs, à comparer tous ces syndromes au syndrome généré pendant l'opération de décodage ECC, et à identifier si le mot mémoire qui vient d'être lu contient un nombre de bits erronés qui dépasse le seuil de n-1.

Une variante de réalisation consiste à vérifier si le mot mémoire qui vient d'être lu génère un syndrome non-nul, indiquant alors la présence de bits erronés, et qui est différent de tous les syndromes générés par des erreurs qui affectent moins de n bits.

Pour les ECCs de type BCH (Bose, Ray-Chaudhuri et Hocquenghem), une variante efficace de détection consiste dans l'évaluation des déterminants de matrices associés à des polynômes de location d'erreur (selon la théorie des codes BCH), tel que cela est décrit dans l'article de J. Freudenberger, M. Rajab et S. Shavgulidze, "A Low-Complexity Three-Error-Correcting BCH Décoder with Applications in Concatenated Codes," publié dans la conférence « International ITG Conférence on Systems, Communications and Coding » en 2019 avec le DOI: 10.30420/454862002.

Avantageusement, le procédé de l'invention considère le nombre d'erreurs détectables mais conventionnellement non-corrigeables et/ou le nombre d'erreurs conventionnellement corrigeables qui affectent un nombre maximum de bits erronés (n-erreur), pour déterminer si le seuil du nombre maximal de bits corrigeables par l'ECC est dépassé.

Si cela est vérifié, dans une étape suivante 340, le procédé permet d'effectuer de nouvelles mesures de résistances des dispositifs résistifs présents dans chaque cellule mémoire à l'adresse lue, pour identifier des weak-bits.

Le principe général est que tout bit lu dont la valeur change au cours des nouvelles évaluations est étiqueté comme étant un « weak-bit ».

Le procédé poursuit par une étape 350 consistant à inverser tous les weak-bits identifiés, puis à effectuer un deuxième décodage ECC du mot initial avec tous les weak-bits inversés.

Des solutions pour identifier et inverser les weak-bits dans des mémoires de type 1T1R et 2T2R sont présentées dans le papier précité de V. Gherman, L. Ciampolini, S. Evain et S. Ricavy, "Error Correction Improvement based on Weak-Bit-Flipping for Resistive Memories," Microelectronics Reliability, volume 136, du 2022.

Comme lors du premier décodage 320, le deuxième décodage de l'étape 350 permet de signaler la présence d'une n-erreur et/ou d'une erreur détectable mais non-corrigeable.

Revenant à la figure 3, l'étape suivante 360 consiste à déterminer et sélectionner la version du mot de code corrigé qui présente le moins de bits erronés, entre le mot initial après le premier décodage (étape 320) et le mot avec inversion de weak-bits après le deuxième décodage (étape 360).

Le procédé permet que le mot décodé en deuxième décodage après inversion des weak-bits à l'étape 350 soit choisi si et seulement si :

- le premier décodage à l'étape 320 a indiqué une erreur non-corrigeable ; ou
- le second décodage à l'étape 350 n'a indiqué ni une n-erreur, ni une erreur non-corrigeable.

Dans les cas où chacun des deux décodages indique une erreur détectable mais non-corrigeable, le procédé permet d'envoyer un signal d'alerte au niveau système.

Le procédé se termine par une étape 370 consistant à délivrer à l'hôte le mot de code qui a été sélectionné à l'étape précédente.

Ainsi, par l'identification d'erreurs conventionnellement corrigeables qui affectent un nombre maximum de bits erronés (n-erreur) et/ou l'identification d'erreurs détectables conventionnellement non-corrigeables, le procédé de l'invention permet de corriger davantage d'erreurs sans augmenter le nombre de bits de vérification.

Comme déjà indiqué, un ECC binaire et linéaire de type bloc est un ensemble de mots de code binaires de taille fixe dont chaque mot de code $v$ peut être défini à l'aide d'une matrice de parité binaire $H$. La matrice $H$ d'un ECC de type BCH est capable de corriger jusqu'à $n$ bits par mot de code.

Une telle matrice a une structure similaire à celle d'une matrice de type Vandermonde représentée comme suit :

$$H = \begin{bmatrix} \alpha^0 & \alpha^1 & \alpha^{1\cdot2} & & \alpha^{1\cdot(l-1)} \\ \alpha^0 & \alpha^2 & \alpha^{2\cdot2} & & \alpha^{2\cdot(l-1)} \\ \alpha^0 & \alpha^3 & \alpha^{3\cdot2} & \cdots & \alpha^{3\cdot(l-1)} \\ \vdots & \vdots & \vdots & & \vdots \\ \alpha^0 & \alpha^{2n} & \alpha^{2n\cdot2} & & \alpha^{2n\cdot(l-1)} \end{bmatrix},$$

où $l$ est le nombre de bits par mot de code et a est un m-uplet vertical représentant l'élément primitif d'un corps fini GF($2^m$) avec $2^{m-1}-1 < l \le 2^m-1$.

Pendant le décodage d'un mot de code $v$ appartenant à un ECC de type BCH capable de corrigé jusqu'à $n$ bits erronés par mot de code (le décodage d'un mot de code servant à trouver et corriger les bits qui sont erronés), la relation donnée par l'équation (1) peut être décomposée en plusieurs expressions, chacune correspondant à une ligne de la matrice $H$, et peut être formulée comme suit par l'équation (2) :

$$s_i = \sum_{j=0}^{l-1} \alpha^{i*j} v_j = \sum_{l=0}^{l-1} \alpha^{i*j} e_j, \tag{2}$$

où $v_j$ est un bit du mot de code et $s_i$ est un composant de syndrome représenté comme élément du corps fini GF($2^m$) avec $1 \leq i \leq 2n$.

L'équation (2) est formulée en utilisant les bits $e_j$ du vecteur d'erreur. Par définition, un bit $e_j$ d'un vecteur d'erreur est égal à 1 seulement si le bit correspondant dans le mot de code $v_j$ est erroné. L'expression (2) reflète le fait qu'en absence d'erreurs, tous les bits du syndrome $s$ deviennent égaux à zéro en accord avec l'équation (1), et tous les composants $s_i$ deviennent égaux à l'élément zéro du corps fini GF($2^m$).

Il peut être montré que le décodage d'un mot de code $v$ peut alors être effectué à l'aide d'un « *polynôme de location d'erreurs* » selon l'équation (3):

$$\sigma(X) = 1 + \sigma_1 X + \cdots + \sigma_{i-1} X^{i-1} + \sigma_i X^i$$

$$= \left(1 + \alpha^{j_1} X\right)\left(1 + \alpha^{j_2} X\right) \cdots \left(1 + \alpha^{j_i} X\right) \tag{3}$$

où $j_1, ..., j_i$ représentent les indices (ou les positions) des bits erronés dans le mot de code.

Une fois le polynôme $\sigma(X)$ établi, la valeur de $\sigma(\alpha^j)$ peut être évaluée pour toutes les valeurs $j$ correspondant à des indices de bits (de données) dans le mot de code $v$ afin de localiser tous les bits (de données) erronés. Cette recherche peut être effectuée en parallèle. Si besoin, les bits de vérification du mot de code $v$ peuvent être aussi générés par l'encodeur ECC à partir de bits de données corrigées.

Des expressions pour les coefficients du polynôme $\sigma(X)$ peuvent être trouvées en partant des identités de Newton formalisées par l'équation matricielle suivante :

$$\begin{bmatrix} 1 & 0 & 0 & 0 \\ s_2 & s_1 & 1 & 0 \\ s_4 & s_3 & s_2 & 0 \\ \vdots & \vdots & \vdots & \cdots & \vdots \\ s_{2i-4} & s_{2i-5} & s_{2i-6} & s_{i-3} \\ s_{2i-2} & s_{2i-3} & s_{2i-4} & s_{i-1} \end{bmatrix} \cdot \begin{pmatrix} \sigma_1 \\ \sigma_2 \\ \vdots \\ \sigma_i \end{pmatrix} = \begin{pmatrix} s_1 \\ s_3 \\ \vdots \\ s_{2i-1} \end{pmatrix}$$

Les expressions de $\sigma_j$ résultant de cette équation dépendent du nombre de bits erronés dans un mot de code et peuvent être établies lors de la conception d'un décodeur ECC.

Si on note par $D_i$ le déterminant de la matrice $i \times i$ intervenant dans le membre gauche de l'équation précédente, il peut être montré que $D_i$ est, soit égal à zéro si le nombre de bits erronés dans un mot de code est plus petit que $i$-$1$, soit différent de zéro si le nombre de bits erronés dans un mot de code est égal à $i$-$1$ ou à $i$.

En suivant le même raisonnement, des matrices similaires avec leurs déterminants peuvent être définies pour des valeurs de $i$ comprises entre $2$ et $n+1$, $n$ étant le nombre maximum de bits erronés corrigeable par mot de code.

Un ECC capable de corriger jusqu'à $n$ bits par mot de code peut être étendu pour permettre la détection supplémentaire d'erreurs affectant $n+1$ bits par mot de code, en rajoutant un bit de vérification supplémentaire afin d'imposer une parité totale fixe à tous les mots de code. Ceci permet d'augmenter d'une unité la distance de Hamming minimale entre les mots de code. Par la suite, sans perte de généralité, il est considéré qu'un tel bit de parité totale est choisi de telle manière que tous les mots de code d'un ECC étendu soient pairs.

Les déterminants $D_i$ peuvent ainsi être utilisés pour déterminer le nombre de bits erronés dans un mot de code, éventuellement en combinaison avec une évaluation de la propriété d'une parité totale fixe, si cela est disponible.

Selon ce qui précède, le nombre $n$ de bits erronés dans un mot de code pour un ECC de type BCH peut être détecté en évaluant si le déterminant $Dn+1$ est soit égal à zéro si le nombre de bits erronés est plus petit que n, soit est différent de zéro si le nombre de bits erronés est égal à n ou à n+1. Ceci permet de plus une détection non-conventionnelle des erreurs affectant n+1 bits, erreurs pouvant générer des syndromes identiques à ceux générés par des erreurs affectant n bits.

La présence des erreurs affectant n ou n+1 bits dans un mot de code pour un ECC de type BCH avec une distance de Hamming minimale entre les mots de code est égale à 2n+1 ($d_H$ = 2n+1), peut être indiquée par un signal d'alarme ou d'alerte calculé par l'évaluation des déterminants, selon l'équation (4) suivante :

$$alarm_{ECC} = \bigvee D_{n+1}, \qquad (4)$$

où l'expression de droite représente l'opérateur « *ou logique* » sur tous les bits du déterminant $D_{n+1}$ (qui est un élément du corps fini GF($2^m$)).

Un mode de réalisation perfectionné de l'invention vise la mise en oeuvre du procédé décrit en référence à la figure 3 pour un ECC ayant une distance de Hamming minimale entre les mots de code égale à 2n+2 ($d_H$ =2n+2).

Pour un ECC avec $d_H$=2n+2, le seuil de comparaison de l'étape 330 de la figure 3 reste égal à *n-1*, ce qui permet toujours la correction des erreurs affectant jusqu'à *n* bits ou la détection des erreurs affectant n+1 bits.

Cependant, dans le cas d'un ECC avec une distance de Hamming minimale entre les mots de code égale à $d_H$=2n+2, l'intérêt est de pouvoir détecter et corriger des erreurs qui affectent jusqu'à *n+2* bits. Or, l'application directe de l'équation (4) pour évaluer un déterminant $D_{n+2}$ nécessiterait la présence des composants de syndrome $s_{2n+1}$ et $s_{2n+2}$ calculés selon l'équation (2). Ceci nécessiterait des bits de vérification supplémentaires, et par voie de conséquence, entraînerait un surcoût en capacité de stockage.

Aussi, les inventeurs proposent une approche différente sans surcoût d'implémentation, conservant le même procédé de détection et sa mise en oeuvre sur les mêmes circuits, afin de détecter et corriger des erreurs qui affectent jusqu'à *n+2* bits.

Le principe consiste à appliquer une variante de l'équation (4) pour générer un signal d'alerte 'alarm$_{ECC}$' indiquant la présence d'erreurs jusqu'à n+2 bits, par une évaluation de la valeur des déterminants $D_i$ d'une matrice de parité *H* établie pour l'ECC concerné et selon la valeur de *n*.

Un premier exemple s'applique dans le cas où *n* est égal à *2* avec un code BCH de type DEC-TED. Le but est alors de détecter des erreurs qui affectent jusqu'à 4 bits (n+2) dans un mot de code.

L'équation (4) est alors déclinée dans une variante (5) afin de déterminer la présence d'une telle erreur et générer un signal d'alarme 'alarm$_{DEC-TED}$'.

Les moyens pour déterminer dans chaque version du mot de code décodée, pour déterminer dans chaque version du mot de code décodée, si un nombre d'erreurs est plus grand que 'n-1=1', s'appuient sur l'évaluation de l'équation (5) suivante :

$$alarm_{DEC-TED} = \left( \overline{\sum v} \wedge \bigvee D_2 \right) \vee \bigvee D_3 \qquad (5)$$

où :

- $D_2$ et $D_3$ sont des déterminants $D_i$ définis comme indiqué précédemment pour un ECC BCH de type DEC-TED ;
- $\Sigma v$ représente l'opérateur logique « *ou-exclusif* » sur tous les bits d'un mot de code *v* reçu, le résultat donnant la parité totale du mot *v*;
- une ligne au-dessus d'une expression logique indique l'opérateur de « *négation logique* »;
- le symbole '∧' désigne l'opérateur « *et logique* »;
- $\vee D_i$ indique l'opérateur « *ou logique* » sur tous les bits d'un déterminant $D_i$ tel que défini précédemment.

Un deuxième exemple s'applique dans le cas où *n* est égal à *3* avec un code BCH de type TEC-QED. Le but est de détecter des erreurs qui affectent jusqu'à 5 bits dans un mot de code.

L'équation (4) est alors déclinée dans une variante (6) afin de déterminer la présence d'une telle erreur et générer un signal d'alarme 'alarm$_{TEC-QED}$'.

Les moyens pour déterminer dans chaque version du mot de code décodée, si un nombre d'erreurs est plus grand que 'n-1=2', s'appuient sur l'évaluation de l'équation (6) suivante :

$$alarm_{TEC-QED} = \left( \sum v \wedge \bigvee D'_3 \right) \vee \bigvee D_4 \qquad (6)$$

où, en plus des notations communes avec l'équation (5) :

- $D'_3$ est le déterminant de la matrice suivante avec les éléments $s_i$ définis par l'équation (2):

$$D'_3 = \begin{vmatrix} s_3 & 1 \\ s_5 & s_2 \end{vmatrix}$$

- $D_4$ est un déterminant défini comme indiqué précédemment pour un ECC BCH de type TEC-QED.

Un troisième exemple s'applique dans le cas où $n$ est égal à $4$ avec un code BCH de type QEC-QED. Le but est de détecter des erreurs qui affectent jusqu'à 6 bits dans un mot de code.

L'équation (4) est alors déclinée dans une variante (7) afin de déterminer la présence d'une telle erreur et générer un signal d'alarme 'alarm$_{QEC-QED}$'.

Les moyens pour déterminer dans chaque version du mot de code décodée, si un nombre d'erreurs est plus grand que 'n-1=3', s'appuient sur l'évaluation de l'équation (7) suivante :

$$alarm_{QEC-QED} = \left[\overline{\sum v} \wedge \left(\bigvee D_4 \vee \bigvee D'_4\right)\right] \vee \bigvee D_5 \quad (7)$$

où $D_4$ et $D_5$ sont des déterminants définis comme indiqué précédemment pour un ECC BCH de type QEC-QED, et où $D'_4$ est le déterminant de la matrice suivante avec les composants $s_i$ définis par l'équation (2):

$$D'_4 = \begin{vmatrix} s_1 & 1 & 0 \\ s_3 & s_2 & s_1 \\ s_7 & s_6 & s_5 \end{vmatrix}.$$

Il a été illustré trois exemples de calcul d'un signal d'alerte pour des valeurs de n=2, n=3 et n=4. L'homme du métier considérera que d'autres cas peuvent être dérivés de ces trois exemples en appliquant de mêmes principes d'une adaptation de l'équation (4) au cas considéré pour évaluation la valeur du signal d'alarme.

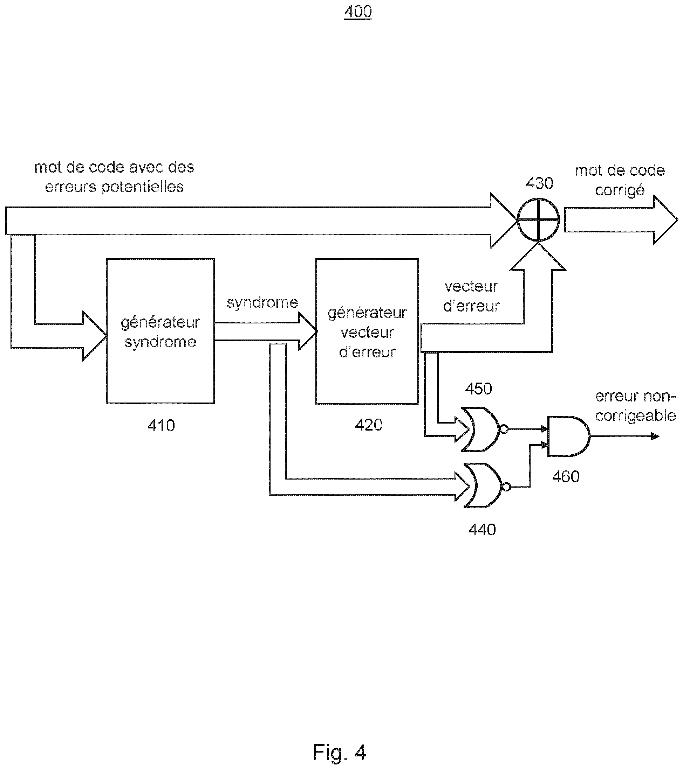

La figure 4 illustre une architecture d'un décodeur ECC qui peut être utilisé dans un contrôleur mémoire pour la mise en oeuvre du procédé de l'invention, pour un mode de réalisation de détection d'erreurs conventionnellement non-corrigeables.

Lors d'une opération de lecture d'un mot mémoire initial, le décodeur ECC 400 reçoit un mot de code potentiellement affecté par des erreurs de programmation, de stockage ou de lecture. A partir de ce mot, un syndrome est généré par un générateur de syndrome (module 410) qui implémente des opérations de multiplication pour réaliser le produit matriciel $H \cdot v$ (Equation (1)).

En fonction du syndrome obtenu il est possible de déterminer si un quelconque bit lu est erroné, tant que le nombre total de bits erronés ne dépasse pas un nombre maximal n de bits corrigeables par l'ECC.

A partir du syndrome, un générateur de vecteur d'erreur (module 420) génère un bit de contrôle pour chaque bit lu. L'ensemble de bits de contrôle est appelé vecteur d'erreur où les bits de contrôle dont la valeur est égale à 1 indiquent les positions des bits erronés dans le mot lu.

Chaque bit lu peut être corrigé à l'aide d'une porte logique ou-exclusive (*xor*) à deux entrées, une entrée pour le bit à corriger dans le mot initialement lu et une autre entrée pilotée par le bit de contrôle qui lui correspond dans le vecteur d'erreur. Un module de correction 430 contient l'ensemble des portes *xor*.

Le mot de code corrigé de manière conventionnelle est délivré par le module 430.

La grande majorité des ECCs utilisés pour la protection des mémoires sont en capacité de fournir des informations qui ne sont pas uniquement liées à des erreurs corrigeables et permettent de détecter des syndromes qui ne sont pas associés à des erreurs conventionnellement corrigeables.

Avantageusement, le dispositif de l'invention utilise de telles informations de nombre d'erreurs pour la détection d'erreurs qui ne sont pas conventionnellement corrigeables.

Ces informations peuvent correspondre :

- à un sous-ensemble de (n+1)-erreurs, pour un ECC avec une distance de Hamming minimale égale à 2n+1 ;
- à toutes les (n+1)-erreurs et éventuellement un sous-ensemble de (n+2)-erreurs, pour un ECC avec une distance de Hamming minimale égale à 2n+2.

La détection et l'utilisation de ces informations est effectuée en modifiant un décodeur conventionnel. Sur l'exemple du décodeur ECC de la figure 4, il est proposé d'implémenter des circuits comprenant une porte ou-logique 440 (communément appelée porte « *or* »), une porte non-ou-logique 450 (communément appelée porte « *nor* ») et une porte et-logique 460 (communément appelée porte « *and* »).

La porte *or* 440 reçoit en entrée les bits du syndrome issu du générateur de syndrome 410.

La porte *nor* 450 reçoit en entrée les bits du vecteur d'erreur issu du générateur de vecteur d'erreur 420.

Les sorties de la porte *or* 440 et de la porte *nor* 450 deviennent les entrées de la porte *and* 460 qui délivre un signal qui est représentatif d'une erreur non-corrigeable.

Cette configuration permet (1) de vérifier par le résultat de la porte *or* si au moins un bit de syndrome est différent de 0 (un syndrome dont tous les bits sont égaux à 0 indique l'absence d'erreur), et permet (2) de vérifier par le résultat de la porte *nor* si tous les bits du vecteur d'erreurs sont égaux à 0. La combinaison des sorties par la porte *and* fournit l'information de la présence ou non d'erreur non-corrigeable.

Dans le cas d'ECCs ayant une distance de Hamming minimale égale à 2n+2, le mécanisme de détection peut être simplifié en tirant profit du fait que les mots de code sont tous pairs ou impairs. L'homme du métier peut dériver des variantes d'implémentation selon le code correcteur d'erreur utilisé.

Pour des codes de type BCH (Bose, Ray-Chaudhuri et Hocquenghem), d'autres méthodes de détection sont décrites dans l'article précité de J. Freudenberger, M. Rajab and S. Shavgulidze.

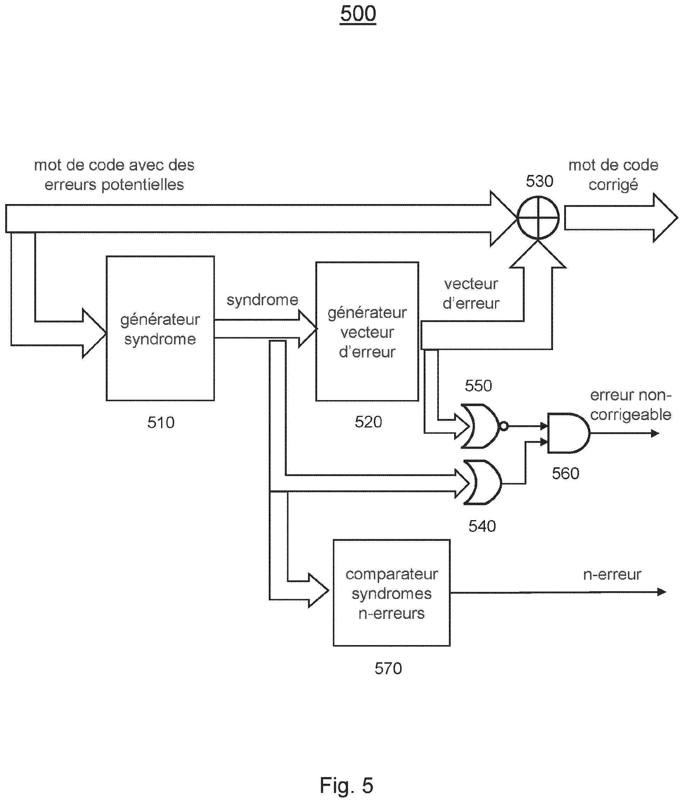

La figure 5 illustre un autre mode de réalisation de l'architecture d'un décodeur ECC qui peut être utilisé dans un contrôleur mémoire pour la mise en oeuvre du procédé de l'invention.

Le décodeur 500 comprend des circuits (510, 520, 530, 540, 550, 560) respectivement similaires fonctionnellement aux circuits (410, 420, 430, 440, 450, 460) du décodeur 400 de la figure 4, qui ne sont pas décrits de nouveau.

Dans cette variante de réalisation, le décodeur 500 comprend de plus un circuit comparateur de syndromes 570 qui permet de générer un signal 'n-erreur' indicateur de la présence ou non d'une n-erreur.

Le circuit 570 est configuré pour comparer le syndrome généré pendant l'opération de décodage ECC à tous les syndromes qui peuvent être générés par une n-erreur afin d'identifier si le mot mémoire qui vient d'être lu est affecté par une telle erreur. Une implémentation moins coûteuse consiste à vérifier si le syndrome généré lors d'une opération de décodage est non-nul, ce qui indique la présence des bits erronés, et qui est différent de tous les syndromes générés par des erreurs qui affectent moins de n bits.

Ce signal peut être utilisé pendant les étapes de premier décodage 320 et de deuxième décodage 350 pour vérifier si le mot mémoire qui vient d'être lu et décodé (sans ou avec inversion de weak-bits) contient un nombre de bits erronés qui dépasse un certain seuil.

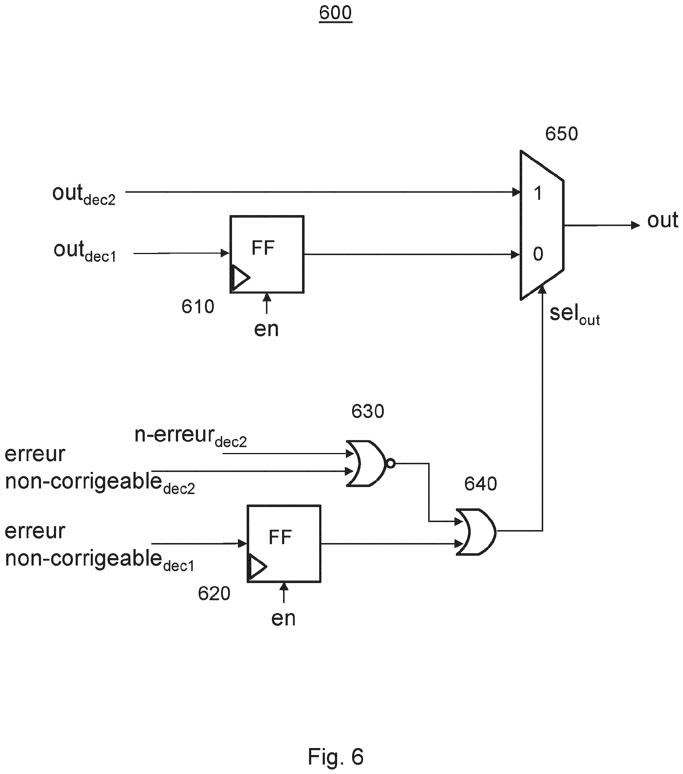

La figure 6 illustre un mode de réalisation d'un circuit permettant de sélectionner un mot corrigé, selon l'étape 360.

Le circuit de sélection 600 est un dispositif couplé à chaque bit en sortie d'un décodeur ECC, et est configuré pour permettre de faire un choix entre un bit corrigé sans ou avec inversion des weak-bits, i.e. selon le résultat des étapes 320 ou 350.

En opération après l'étape 320 de premier décodage, chaque bit d'un mot décodé (i.e. le signal $out_{dec1}$) et le bit du signal *erreur non-corrigeable$_{dec1}$* qui sortent du décodeur ECC (par exemple celui de la figure 4), sont stockés respectivement dans une bascule 610, 620.

Un signal 'en' est utilisé pour synchroniser la capture des signaux en entrées des bascules 610 et 620, avec la fin de la première opération de décodage de l'étape 320.

En opération après l'étape 350 de deuxième décodage, le signal *n-erreur* et le signal *erreur non-corrigeable$_{dec2}$* sont combinés par une même porte logique de type *nor* 630.

Contrairement au premier décodage, le signal *erreur non-corrigeable$_{dec2}$* délivré après le deuxième décodage n'est pas stocké (i.e. dans la bascule 620), et le signal $out_{dec2}$ n'est pas stocké (i.e. dans la bascule 610).

La sortie de la porte *nor* 630 est combinée dans une porte logique *or* 640 avec le bit du signal *erreur non-corrigeable$_{dec1}$* qui a été stocké dans la bascule 620 après le premier décodage, pour délivrer un signal de sélection $sel_{out}$.

Le signal de sélection $sel_{out}$ pilote un multiplexeur 650 pour délivrer un signal de sortie *out* correspondant au bit sélectionné (i.e. le bit corrigé après le premier décodage ou après le deuxième décodage avec inversion de weak-bits).

Le multiplexeur 650 prend en entrées, le signal $out_{dec2}$ en sortie du décodeur après le deuxième décodage et le signal $out_{dec1}$ qui a été stocké dans la bascule 610 après le premier décodage.

En opération, la sortie de la porte *nor* 630 permet de fournir un signal indiquant si le décodeur ECC (qui permet la correction d'un maximum de n bits erronés par mot de code) a dû gérer une erreur qui affecte au maximum n-1 bits erronés.

Ainsi, après l'étape 350, si aucun des deux bits d'entrée de la porte *nor* 630 n'est égal à 1 (le second décodage n'a indiqué ni une n-erreur, ni une erreur non-corrigeable), et s'il n'y pas eu d'erreur non-corrigeable pendant l'étape 320 de premier décodage, le signal $sel_{out}$ permet sur le multiplexeur 650 de sélectionner le signal $out_{dec2}$, c'est-à-dire le mot décodé lors de l'étape 350, i.e. avec inversion de weak-bits.

Par ailleurs, si le décodeur ECC indique une erreur non-corrigeable pendant l'étape de premier décodage 320, la porte *or* 640, qui prend la sortie de la porte *nor* 630 et la sortie de la bascule 620, génère un signal $sel_{out}$ qui permet au

multiplexeur 650 aussi de sélectionner le signal out$_{dec2}$, c'est-à-dire le mot décodé lors de l'étape 350, i.e. avec inversion de weak-bits.

Les valeurs des bits en sortie du décodeur ECC à la fin de l'étape 350 de deuxième décodage, sont conservées au moins jusqu'à la fin de l'étape 360 de sélection du mot corrigé.

Une bascule 610 et un multiplexeur 650 doivent être fournis pour chaque bit corrigé qui sort du décodeur ECC dans le contrôleur mémoire 120.

Dans le cas où l'étape 330 a indiqué que le nombre de bits erronés est inférieur au seuil (branche non), une distinction entre des signaux de même nom mais des index différents (dec1, dec2) n'a plus de sens. Dans ce cas, les deux signaux *n-erreur$_{dec2}$* et *erreur non-corrigeable$_{dec2}$* en entrée de la porte 630 sont à 0, et le signal *sel$_{out}$* est à 1, permettant alors de sélectionner le mot initial corrigé sans inversion de weak-bits, i.e. le signal out$_{dec2}$ tel qu'indiqué en figure 6.

Dans le cas où le décodeur ECC indique une erreur non-corrigeable à la fin de chacune des deux étapes de décodage 320 et 350, le contrôleur mémoire indique une erreur non-corrigeable à l'hôte qui a fait la requête de lecture mémoire.

Dans un mode de réalisation, les bascules 610 et 620 sont des circuits de type verrous.

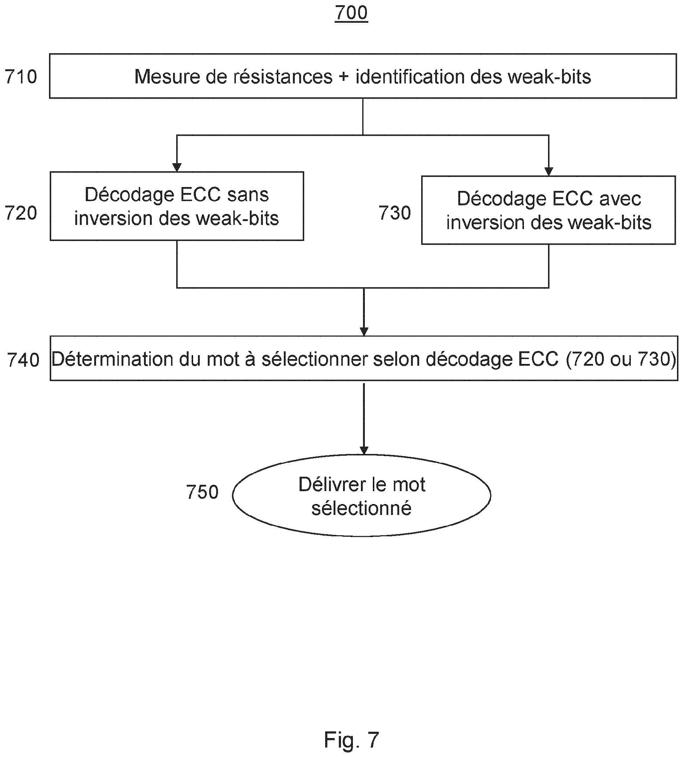

La figure 7 illustre les étapes du procédé de lecture avec correction d'erreurs de l'invention dans un autre mode de réalisation. Le procédé 700 débute par une étape 710 de mesures de résistances avec identification de weak-bits.

L'étape 710 correspond à des mesures de résistance, d'une part par comparaison avec une valeur de référence telles que les mesures décrites pour l'étape 310, et d'autre part par comparaison avec une valeur de référence modifiée (i.e. légèrement supérieure et légèrement inférieure) telles que les mesures décrites pour l'étape 340.

L'étape 710 permet d'identifier les weak-bits.

Une implémentation circuit de l'étape 710 peut être avec trois amplificateurs de détection (ou « triple sense amplifier » en anglais) par bit lu.

Suite à l'étape 710, tous les weak-bits du mot lu à l'adresse mémoire indiquée par l'hôte, sont identifiés.

Le procédé poursuit par deux opérations de décodage du mot, exécutées en parallèle.

Un premier décodage ECC (étape 720) est fait sans inversion de weak-bits, et un deuxième décodage ECC (étape 730) est fait simultanément avec tous les weak-bits inversés tels qu'ils ont été identifiés lors des mesures de résistances avec la valeur de référence modifiée.

Dans ce mode de réalisation, le contrôleur mémoire 120 contient deux décodeurs ECC.

Après les étapes de décodage ECC (720, 730), le procédé permet dans une étape suivante 740 de déterminer et sélectionner la version du mot de code corrigé qui présente le moins de bits erronés, entre la version du mot décodée par le premier décodage sans inversion des weak-bits, et la version du mot décodée par le deuxième décodage avec inversion de weak-bits.

Le procédé se termine par une étape 750 consistant à délivrer le mot corrigé qui est sélectionné.

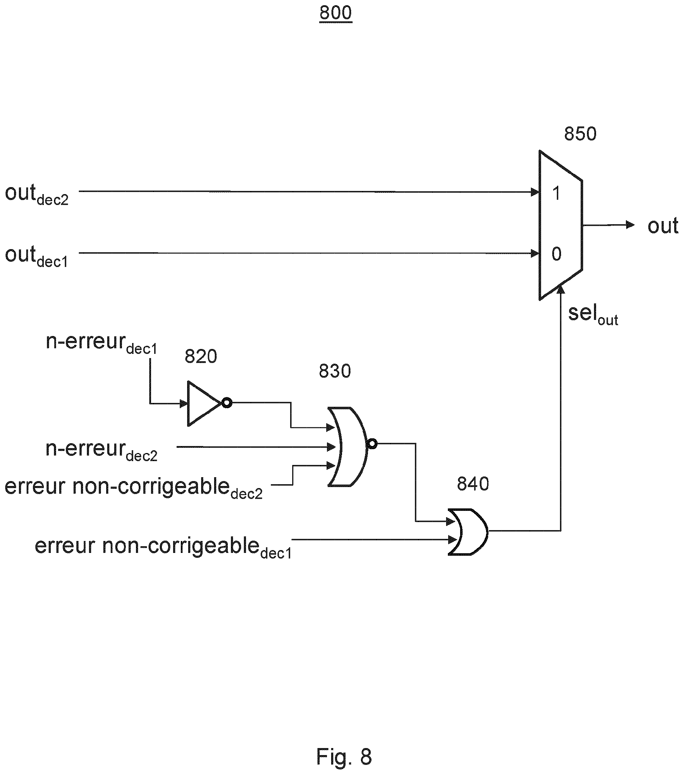

Une implémentation circuit du procédé 700 est illustré en figure 8. Elle est basée sur un dispositif similaire à celui de la figure 6, où la porte logique or 840 et le multiplexeur 850 sont équivalents à la porte logique or 640 et au multiplexeur 650 de l'implémentation montrée en figure 6.

Le circuit de la figure 8 comprend de plus une porte logique 820 qui permet d'inverser le signal d'entrée n-erreur$_{dec1}$, signal d'information d'erreur indiquant la présence de plus de n-1 erreurs dans le mot de code décodé sans inversion de weak-bits (étape 720).

Le circuit comprend aussi une porte nor 830 équivalente en fonction à la porte nor 630 de la figure 6, mais ayant une entrée supplémentaire produite par la sortie de la porte 820.

Les signaux permettant de générer des informations d'erreur pour déterminer le mot corrigé à délivrer, sont d'une part générés par un décodeur ECC réalisant le décodage sans inversion de weak-bits (signaux notés « out$_{dec1}$», « n-erreur$_{dec1}$» et « erreur non-corrigeable$_{dec1}$»), et d'autre part générés par un décodeur ECC réalisant le décodage avec inversion de weak-bits (signaux notés « out$_{dec2}$», « n-erreur$_{dec2}$ » et « erreur non-corrigeable$_{dec2}$»).

Comme indiqué, le procédé de l'invention permet d'augmenter le gain en capacité de correction d'erreurs en effectuant des opérations d'identification et d'utilisation des weak-bits, à la détection d'une erreur non-corrigeable mais aussi en présence de certaines erreurs corrigeables.

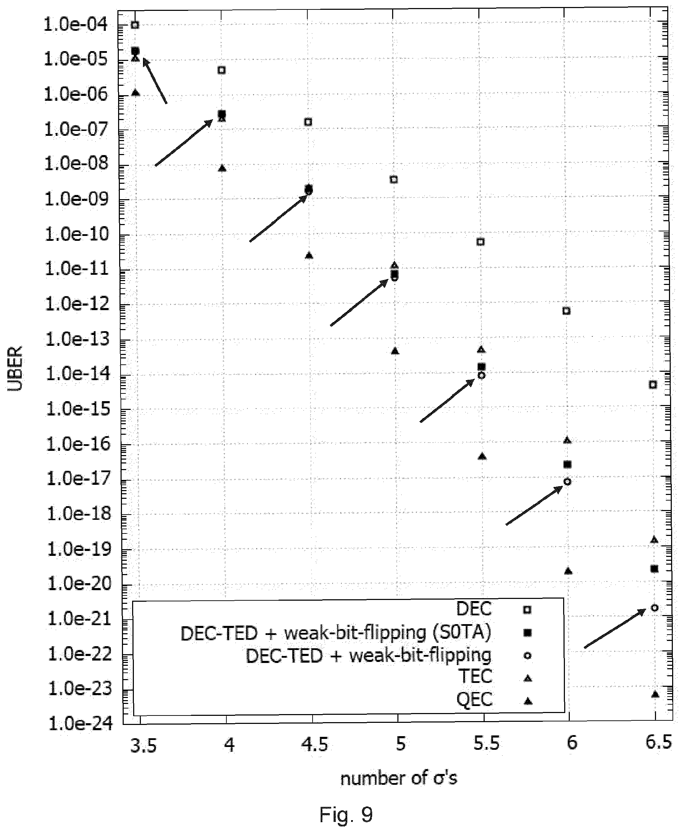

La figure 9 est un graphe montrant des taux de correction d'erreurs obtenus avec des solutions de l'art antérieur (SOTA, DEC, TEC, QEC) et avec le procédé de la présente invention.

L'ordonnée du graphe pointe la métrique « UBER » (acronyme de l'anglais « Uncorrectable Bit Error Rate ») qui caractérise le taux d'erreurs après décodage selon différents types de code correcteur d'erreur ECC, appliqué à une mémoire résistive configurée en 2T2R avec 32 bits de données par mot mémoire.

Il est présenté en abscisse le nombre de sigmas entre les valeurs moyennes des distributions des différences des résistances électriques HRS-LRS et LRS-HRS utilisées en 2T2R pour encoder les valeurs 1 et 0 logiques.

Les points du graphe relevés par les indicateurs DEC, TEC et QEC représentent les taux d'erreur obtenus avec des codes correcteurs conventionnels de type DEC, TEC et QEC respectivement.

Les points du graphe relevés par l'indicateur « SOTA » (acronyme de l'anglais « State-Of-The-Art ») représentent les résultats obtenus avec la solution présentée dans le papier précité de V. Gherman, L. Ciampolini, S. Evain et S. Ricavy, "Error Correction Improvement based on Weak-Bit-Flipping for Resistive Memories," Microelectronics Reliability, volume 136, 2022.

Les points du graphe relevés par l'indicateur « DEC-TED + weak-bit-flipping » représentent les taux d'erreur obtenus avec le procédé de l'invention.

Il ressort que la solution proposée permet de réduire le taux d'erreur de plus d'un ordre de magnitude (dans certaines conditions).

Quelques exemples communs de codes correcteurs d'erreur sont les suivants :

- un DEC qui a une capacité de correction de maximum deux bits erronés par mot de code ;
- un DEC-TED qui permet la correction d'au maximum deux bits erronés et la détection de trois bits erronés par mot de code ;
- un TEC qui a une capacité de correction d'au maximum trois bits erronés par mot de code ;
- un TEC-QED qui permet la correction d'au maximum trois bits erronés et la détection de quatre bits erronés par mot de code ;
- un QEC qui permet la correction d'au maximum quatre bits erronés par mot de code ;
- un QEC-QED qui permet la correction d'au maximum quatre bits erronés et la détection de cinq bits erronés par mot de code.

Il est à noter qu'un code DEC nécessite 12 bits de vérification par mot de code avec 32 bits de données, et qu'un code DEC-TED nécessite 13 bits de vérification pour le même nombre de bits de données par mot de code. Les codes TEC et QEC nécessitent respectivement 18 bits et 24 bits de vérification par mot de code avec 32 bits de données.

La présente description illustre une implémentation préférentielle de l'invention, mais qui n'est pas limitative. Des exemples sont choisis pour permettre une bonne compréhension des principes de l'invention et une application concrète, mais ne sont en rien exhaustifs et doivent permettre à l'homme du métier d'apporter des modifications et des variantes d'implémentation aux différents circuits en conservant les mêmes principes. Dans des variantes de réalisation, chaque module fonctionnel d'encodage, de comptage, de comparaison et d'inversion peut être implémenté par un module dédié tel qu'un ASIC.

L'invention peut s'implémenter à partir d'éléments matériels et/ou logiciels. Elle peut être disponible en tant que produit programme d'ordinateur exécuté par un processeur dédié ou par un contrôleur mémoire d'un système de stockage, et qui comprend des instructions de code pour exécuter les étapes des procédés dans leurs différents modes de réalisation.

**Revendications**

1. Dispositif de lecture d'un mot de code stocké dans une mémoire résistive où chaque cellule mémoire comprend des dispositifs résistifs pour stocker un bit d'un mot de code, le dispositif de lecture comprenant :

   - des moyens pour mesurer (310) la résistance de chaque dispositif résistif stockant un bit d'un mot de code à lire, et pour identifier des bits faibles ;
   - des moyens pour effectuer avec un décodeur d'un code correcteur d'erreur ayant une capacité de correction maximale de n bits erronés, un premier (320) et un deuxième décodage (350) du mot de code, les premier et deuxième décodages étant respectivement effectués sans et avec inversion des bits faibles ;
   - des moyens pour déterminer (330) dans chaque version du mot de code décodée, des informations de nombre d'erreurs, quant à des erreurs détectables mais non-corrigeables selon la capacité de correction dudit code correcteur d'erreur et quant à des erreurs corrigeables selon la capacité de correction dudit code correcteur d'erreur et qui affectent un nombre maximum de bits erronés ; et
   - des moyens pour sélectionner (360) en fonction des informations de nombre d'erreurs, la version du mot de code décodée qui contient le moins de bits erronés.

2. Le dispositif selon la revendication 1 dans lequel les moyens de sélection permettent de sélectionner la version du mot de code décodée sans inversion de bits faibles si l'information de nombre d'erreurs pour la version du mot de code décodée sans inversion de bits faibles ne fournit pas un nombre d'erreurs plus grand que n-1.

3. Le dispositif selon la revendication 1 ou 2 dans lequel les moyens de sélection permettent de sélectionner la version du mot de code décodée avec inversion de bits faibles si l'information de nombre d'erreurs pour la version du mot de code décodée sans inversion de bits faibles indique un nombre d'erreurs non-corrigeables ou si l'information de nombre d'erreurs pour la version du mot de code décodée avec inversion des bits faibles ne fournit pas un nombre d'erreurs plus grand que n-1 et l'information n'indique pas d'erreur non-corrigeable.

4. Le dispositif selon l'une quelconque des revendications 1 à 3 dans lequel les moyens pour mesurer la résistance de chaque dispositif résistif comprennent des moyens pour mesurer la résistance de chaque dispositif résistif par rapport à une valeur de résistance de référence.

5. Le dispositif selon l'une quelconque des revendications 1 à 4 dans lequel les moyens pour mesurer la résistance de chaque dispositif résistif comprennent des moyens pour mesurer la résistance de chaque dispositif résistif par rapport à deux valeurs de résistance.

6. Le dispositif selon l'une quelconque des revendications 1 à 5 dans lequel les moyens pour identifier des bits faibles comprennent des moyens pour comparer la résistance mesurée de chaque dispositif résistif à une valeur de résistance légèrement supérieure à la valeur de résistance de référence, et à une valeur de résistance légèrement inférieure à la valeur de résistance de référence, et pour identifier les bits dont les résultats de ces comparaisons de résistance ne sont pas identiques.

7. Le dispositif selon l'une quelconque des revendications 1 à 6 dans lequel les moyens pour effectuer un premier et un deuxième décodage du mot de code comprennent des moyens pour effectuer séquentiellement le premier et le deuxième décodage.

8. Le dispositif selon l'une quelconque des revendications 1 à 7 dans lequel les moyens pour effectuer un premier et un deuxième décodage du mot de code comprennent des moyens pour effectuer simultanément le premier et le deuxième décodage.

9. Le dispositif selon l'une quelconque des revendications 1 à 8 dans lequel le code correcteur d'erreur est de type SEC, SEC-DED, DEC, DEC-TED, TEC, TEC-QED, QEC, QEC-QED.

10. Le dispositif selon l'une quelconque des revendications 1 à 9 dans lequel le code correcteur d'erreur a une distance de Hamming $d_H$ minimale entre les mots de code égale à 2n+2.

11. Le dispositif selon la revendication 10 dans lequel le code correcteur est de type DEC-TED avec une distance de Hamming dn minimale entre les mots de code égale à 2n+2=6, et pour lequel les moyens pour déterminer dans chaque version du mot de code décodée, si un nombre d'erreurs est plus grand que 'n-1=1', s'appuient sur l'évaluation de l'équation (5) suivante :

$$alarm_{DEC-TED} = (\overline{\sum v} \wedge \vee D_2) \vee \vee D_3 \ .$$

12. Le dispositif selon la revendication 10 dans lequel le code correcteur est de type TEC-QED avec une distance de Hamming dn minimale entre les mots de code égale à 2n+2=8, et pour lequel les moyens pour déterminer dans chaque version du mot de code décodée, si un nombre d'erreurs est plus grand que 'n-1=2', s'appuient sur l'évaluation de l'équation (6) suivante :

$$alarm_{TEC-QED} = (\sum v \wedge \vee D'_3) \vee \vee D_4 \quad .$$

13. Le dispositif selon la revendication 10 dans lequel le code correcteur est de type QEC-QED avec une distance de Hamming $d_H$ minimale entre les mots de code égale à 2n+2=10, et pour lequel les moyens pour déterminer dans chaque version du mot de code décodée, si un nombre d'erreurs est plus grand que 'n-1=3', s'appuient sur l'évaluation de l'équation (7) suivante :

$$alarm_{QEC-QED} = [\overline{\sum v} \wedge (\vee D_4 \vee \vee D'_4)] \vee \vee D_5 \ .$$

14. Un système électronique de type FPGA ou ASIC comprenant un dispositif selon l'une des revendications 1 à 13.

15. Procédé (300) de lecture d'un mot de code stocké dans une mémoire résistive où chaque cellule mémoire comprend des dispositifs résistifs pour stocker un bit d'un mot de code, le procédé comprenant au moins des étapes pour :

- mesurer (310) la résistance de chaque dispositif résistif stockant un bit d'un mot de code à lire, et identifier des bits faibles ;
- effectuer avec un décodeur d'un code correcteur d'erreur ayant une capacité de correction maximale de n bits erronés, un premier (320) et un deuxième (350) décodage du mot de code, les premier et deuxième décodages étant respectivement effectués sans et avec inversion des bits faibles ;
- déterminer (330) dans chaque version du mot de code décodée, des informations de nombre d'erreurs, quant à des erreurs détectables mais non-corrigeables selon la capacité de correction dudit code correcteur d'erreur et quant à des erreurs corrigeables selon la capacité de correction dudit code correcteur d'erreur et qui affectent un nombre maximum de bits erronés ; et
- sélectionner (360) en fonction des informations de nombre d'erreurs, la version du mot de code décodée qui contient le moins de bits erronés.

16. Le procédé selon la revendication 15 dans lequel l'étape de décodage consiste à faire séquentiellement un premier décodage sans inversion de bits faibles et un deuxième décodage avec inversion de bits faibles.

17. Le procédé selon la revendication 15 dans lequel l'étape de décodage consiste à faire simultanément un premier décodage sans inversion de bits faibles et un deuxième décodage avec inversion de bits faibles.

18. Le procédé selon l'une quelconque des revendications 15 à 17 dans lequel l'étape de sélection d'un mot de code consiste à :

- sélectionner la version du mot de code décodée sans inversion de bits faibles si l'information de nombre d'erreurs pour la version du mot de code décodée sans inversion de bits faibles ne fournit pas un nombre d'erreurs plus grand que n-1 ; ou
- sélectionner la version du mot de code décodée avec inversion de bits faibles si l'information de nombre d'erreurs pour la version du mot de code décodée avec inversion des bits faibles ne fournit pas un nombre d'erreurs plus grand que n-1 tandis que l'information de nombre d'erreurs pour la version du mot de code décodée sans inversion de bits faibles fournit un nombre d'erreurs plus grand que n-1, ou si l'information de nombre d'erreurs pour la version du mot de code décodée sans inversion de bits faibles indique un nombre d'erreurs non-corrigeables.

**100**

1T1R

FIG.1a

**110**

2T2R

FIG.1b

200

| 210 ▷ | Sous-système électronique (hôte) |

mot de code
(bits de données)

| 220 ▷ | Contrôleur mémoire avec ECC |

mot de code
(bits de données + de vérification)

| 230 | Mémoire résistive |

Fig. 2

<u>300</u>

310 — Mesure des résistances d'un mot mémoire

320 — Décodage ECC

330 — Nombre bits erronés > seuil ? → non

oui

340 — Mesure résistances avec références modifiées + identification des weak-bits

350 — Inversion des bits des weak-bits + décodage ECC

360 — Détermination du mot à sélectionner selon décodage ECC (320 ou 350)

370 — Délivrer le mot sélectionné

Fig. 3

400

mot de code avec des
erreurs potentielles

430

mot de code
corrigé

| générateur syndrome | syndrome | générateur vecteur d'erreur | vecteur d'erreur |

410

420

450

erreur non-
corrigeable

460

440

Fig. 4

<u>500</u>

mot de code avec des
erreurs potentielles

mot de code
corrigé

530

générateur
syndrome

510

syndrome

générateur
vecteur
d'erreur

520

vecteur
d'erreur

550

erreur non-
corrigeable

560

540

comparateur
syndromes
n-erreurs

570

n-erreur

Fig. 5

600

Fig. 6

<u>700</u>

```
710 | Mesure de résistances + identification des weak-bits

720 | Décodage ECC sans          730 | Décodage ECC avec
       inversion des weak-bits          inversion des weak-bits

740 | Détermination du mot à sélectionner selon décodage ECC (720 ou 730)

750      Délivrer le mot
         sélectionné
```

Fig. 7

800

850

out$_{dec2}$ ─────────────────────────────► 1

out$_{dec1}$ ─────────────────────────────► 0 ──────► out

sel$_{out}$

n-erreur$_{dec1}$    820    830

n-erreur$_{dec2}$

erreur non-corrigeable$_{dec2}$    840

erreur non-corrigeable$_{dec1}$

Fig. 8

Fig. 9

Europäisches
Patentamt

European
Patent Office

Office européen
des brevets

**RAPPORT DE RECHERCHE EUROPEENNE**

Numéro de la demande

EP 24 20 5740

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | GHERMAN VALENTIN ET AL: "Error correction improvement based on weak-bit-flipping for resistive memories", MICROELECTRONICS RELIABILITY : AN INTERNAT. JOURNAL & WORLD ABSTRACTING SERVICE , vol. 136 septembre 2022 (2022-09), page 114669, XP093193735, GB ISSN: 0026-2714, DOI: 10.1016/j.microrel.2022.114669 Extrait de l'Internet: URL:https://dx.doi.org/10.1016/j.microrel.2022.114669 * le document en entier * ----- | 1-18 | INV. H03M13/45 G06F11/08 H03M13/15 |
| X | US 2016/179616 A1 (HA JEONG-SEOK [KR] ET AL) 23 juin 2016 (2016-06-23) | 1-10, 14-18 | |
| A | * le document en entier * ----- | 11-13 | DOMAINES TECHNIQUES RECHERCHES (IPC) |
| A | LEE HUANG-CHANG ET AL: "Efficient Chase-2 decoding algorithm for linear block codes", ELECTRONICS LETTERS, THE INSTITUTION OF ENGINEERING AND TECHNOLOGY, GB, vol. 55, no. 17, 22 août 2019 (2019-08-22) , pages 936-938, XP006080043, ISSN: 0013-5194, DOI: 10.1049/EL.2019.1506 * le document en entier * ----- | 1-18 | H03M G06F |

Le présent rapport a été établi pour toutes les revendications

| Lieu de la recherche | Date d'achèvement de la recherche | Examinateur |
|---|---|---|
| Munich | 12 février 2025 | Farman, Thomas |

**EP 4 542 865 A1**

## ANNEXE AU RAPPORT DE RECHERCHE EUROPEENNE
## RELATIF A LA DEMANDE DE BREVET EUROPEEN NO.

EP 24 20 5740

12-02-2025

| Document brevet cité au rapport de recherche | Date de publication | Membre(s) de la famille de brevet(s) | Date de publication |
|---|---|---|---|
| US 2016179616 A1 | 23-06-2016 | KR 20160075001 A | 29-06-2016 |
| | | US 2016179616 A1 | 23-06-2016 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016179616 A1, Ha Jeong-Seok

**Littérature non-brevet citée dans la description**

- **V. GHERMAN** ; **L. CIAMPOLINI** ; **S. EVAIN** ; **S. RICAVY**. Error Correction Improvement based on Weak-Bit-Flipping for Resistive Memories. *Microelectronics Reliability*, 2022, vol. 136

- **J. FREUDENBERGER** ; **M. RAJAB** ; **S. SHAVGU-LIDZE**. A Low-Complexity Three-Error-Correcting BCH Décoder with Applications in Concatenated Codes. *International ITG Conférence on Systems, Communications and Coding*, 2019